# EUROPEAN PATENT APPLICATION

(11) **EP 4 749 689 A1**
(43) Date of publication of application: **27.05.2026**
(21) Application number: 25169226.5
(22) Date of filing: 08.04.2025
(51) Int. Cl.: H01L 25/075, H10H 29/24, H10H 29/85

(54) **DUAL DIE ATTACHMENT LAYER LED PACKAGING HOLDER AND LED MODULE**

(30) Priority: 25.11.2024 CN 202422881487 U
(71) Applicant: Nitelab Optoelectronics Co., Ltd., Foshan, Guangdong 528251 (CN)
(72) Inventor: LI, Wenjie, Fosha, Guangdong 528251 (CN)
(74) Representative: KIPA AB

(57) **Abstract**

A dual die attachment layer LED chip packaging holder and an LED module are provided, relating to the technical field of LED chip packaging holders. The dual die attachment layer LED chip packaging holder includes: a substrate; a centrally raised die attachment area, arranged on the substrate; an annular die attachment area, arranged around an outer side of the centrally raised die attachment area; a thickness of the centrally raised die attachment area is different from a thickness of the annular die attachment area; an electrode layer, arranged on an end surface of the substrate away from the centrally raised die attachment area; both the centrally raised die attachment area and the annular die attachment area are connected to the electrode layer. The dual die attachment layer LED chip packaging holder of the present disclosure includes a centrally raised die attachment area and an annular die attachment area, both areas are connected to an electrode layer, allowing for simultaneous or individual power supply through the electrode layer to enable electrical conduction. Both the centrally raised die attachment area and the annular die attachment area can accommodate LED chips. By adjusting a thicknesses of the annular die attachment area and the centrally raised die attachment area, the optical path of the emitted light can be modified, thereby enhancing the emission range and uniformity of the light.

## Description

### FIELD

The present disclosure relates to the technical field of LED chip packaging holders, and in particular, relates to a dual die attachment layer LED chip packaging holder and an LED module.

### BACKGROUND

At present, LED configurations aimed at achieving various lighting effects, a plurality of LED chips are often placed together, with a plurality of die attachment areas for mounting the chips arranged on the same planar die attachment layer. The lighting effects are adjusted through the switching and distribution of the chips. To facilitate chip mounting and packaging, LED manufacturers produce LED packaging holders featuring a single die attachment layer with a plurality of die attachment areas. However, existing chips are merely assembled in a simplistic manner, resulting in straightforward distributions of die attachment areas that fail to effectively integrate the color temperatures between different chips, leading to non-uniform light emission and a limited emission range. Additionally, the LED chip packaging holder can partially obstruct the light from chips, resulting in dim regions in the emitted light.

Therefore, existing LED chip packaging holders suffer from simplistic die attachment area distributions and inadequate coordination between chips, which limits the ability to improve the uniformity and emission range of the LED light.

### SUMMARY

In view of the deficiencies in the prior art, the present disclosure aims to provide a dual die attachment layer LED chip packaging holder, to solve the problems associated with simplistic die attachment area distributions and the inability of chips to effectively coordinate to enhance the uniformity and emission range of the LED light.

The technical solutions adopted in the present disclosure to solve the problems are as follows: providing a dual die attachment layer LED chip packaging holder, including: a substrate; a centrally raised die attachment area, arranged on the substrate; an annular die attachment area, arranged around an outer side of the centrally raised die attachment area; a thickness of the centrally raised die attachment area is different from a thickness of the annular die attachment area; an electrode layer, arranged on an end surface of the substrate away from the centrally raised die attachment area; both the centrally raised die attachment area and the annular die attachment area are connected to the electrode layer.

Further, the thickness of the centrally raised die attachment area is less than the thickness of the annular die attachment area, and the thickness of the annular die attachment area decreases gradually in the direction approaching the centrally raised die attachment area.

Further, an intersection point of light paths of the annular die attachment area is located on a light path of the centrally raised die attachment area.

Further, the thickness of the centrally raised die attachment area is greater than the thickness of the annular die attachment area; and the thickness of the annular die attachment area increases gradually in a direction approaching the centrally raised die attachment area.

Further, a spacing between the centrally raised die attachment area and the annular die attachment area is less than or equal to a width of the annular die attachment area.

Further, a first through-hole is arranged in the substrate at a position corresponding to the centrally raised die attachment area, and the electrode layer is connected to the centrally raised die attachment area through the first through-hole; a second through-hole is arranged in the substrate at a position corresponding to the annular die attachment area, and the electrode layer is connected to the annular die attachment area through the second through-hole.

Further, the annular die attachment area includes a plurality of annular die attachment segments, each of the annular die attachment segments is connected to the electrode layer.

Further, the electrode layer includes a positive electrode layer and a negative electrode layer, with a gap between the positive electrode layer and the negative electrode layer; the positive electrode layer includes a first positive electrode layer connected to the centrally raised die attachment area and a second positive electrode layer connected to the annular die attachment area; the negative electrode layer includes a first negative electrode layer connected to the centrally raised die attachment area and a second negative electrode layer connected to the annular die attachment area.

Further, an insulating layer is arranged within the gap; the insulating layer is configured to electrically isolate the positive electrode layer and the negative electrode layer.

The present disclosure also provides an LED module, including: a first chip, a second chip, and the aforementioned dual die attachment layer LED chip packaging holder; the first chip is arranged on the centrally raised die attachment area, and the second chip is arranged on the annular die attachment area.

Compared to the prior art, the present disclosure provides a dual die attachment layer LED chip packaging holder and an LED module. The dual die attachment layer LED chip packaging holder of the present disclosure includes a centrally raised die attachment area and an annular die attachment area. Both areas are connected to the electrode layer, allowing for simultaneous or individual power supply through the electrode layer to enable electrical conduction. Both the centrally raised die attachment area and the annular die attachment can accommodate LED chips, by adjusting the thickness of the annular die attachment area and the centrally raised die attachment area, the optical path of the emitted light can be modified, thereby enhancing the emission range and uniformity of the light.

### BRIEF DESCRIPTION OF THE DRAWINGS

FIG. 1 is a top view of a first embodiment of a dual die attachment layer LED chip packaging holder provided in the present disclosure;
FIG. 2 is a top view and a cross-sectional view of an alternative embodiment of the dual die attachment layer LED chip packaging holder provided in the present disclosure;
FIG. 3 is a cross-sectional view of an alternative embodiment of the dual die attachment layer LED chip packaging holder provided in the present disclosure;
FIG. 4 is a cross-sectional view of an alternative embodiment of the dual die attachment layer LED chip packaging holder provided in the present disclosure;
FIG. 5 is a cross-sectional view of an alternative embodiment of the dual die attachment layer LED chip packaging holder provided in the present disclosure;
FIG. 6 is a cross-sectional view of an alternative embodiment of the dual die attachment layer LED chip packaging holder provided in the present disclosure.
FIG. 7 is a top view of an alternative embodiment of the dual die attachment layer LED chip packaging holder provided in the present disclosure.

Attached drawing marks:
1-substrate; 2-centrally raised die attachment area; 3-annular die attachment area; 31-first annular die attachment segment; 32-second annular die attachment segment; 33-third annular die attachment segment; 34-fourth annular die attachment segment; 35-connection groove; 4-electrode layer.

### DETAILED DESCRIPTION OF EMBODIMENTS

The following is a detailed description of the embodiments of the present disclosure, the examples of the embodiments are illustrated in the accompanying drawings, where identical or similar attached drawing marks throughout denote identical or similar elements or elements with identical or similar functions. The embodiments described below with the attached drawings are exemplary and are intended to explain the present disclosure, but should not be construed as limiting the scope of the present disclosure.

In the description of the present disclosure, it should be understood that terms such as "central", "longitudinal", "transverse", "upper", "lower", "front", "rear", "left", "right", "vertical", "horizontal", "top", "bottom", "internal", "external", etc., are used to indicate directions or positional relationships based on the orientation shown in the attached drawings. The terms are used for a convenience of describing the present disclosure and simplifying the description, do not imply that the device or element must have a specific orientation, construction, or mode of operation. Therefore, the terms should not be interpreted as limiting the scope of the present disclosure. Additionally, the terms "first", "second", etc., are used for descriptive purposes only and should not be construed as indicating or implying relative importance or the quantity of the technical features indicated. Therefore, features designated as "first" or "second" may explicitly or implicitly include one or more such features. In the description of the present disclosure, unless otherwise specified, the term "multiple" refers to two or more.

In the description of the present disclosure, it should be noted that unless otherwise explicitly specified or defined, the terms "arrange", "configure," and "connect" shall be broadly construed. For example, this may refer to fixed connections, removable connections, or integral connections; this can be direct connections or indirect connections through an intermediate medium. The ordinary skilled person in the field to which the present disclosure would understand the specific meanings of the terms in the context of the present disclosure according to the specific circumstances.

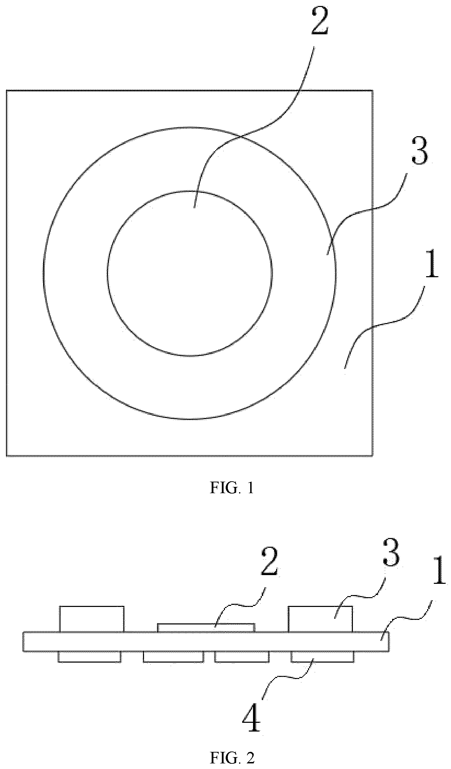

As illustrated in FIG. 1, FIG. 2, and FIG. 3, the first embodiment of the present disclosure provides a dual die attachment layer LED chip packaging holder, which includes: a substrate 1; a centrally raised die attachment area 2, arranged on the substrate; an annular die attachment area 3, arranged around an outer side of the centrally raised die attachment area 2; a thickness of the centrally raised die attachment area 2 is different from a thickness of the annular die attachment area 3; an electrode layer 4, arranged on an end surface of the substrate away from the centrally raised die attachment area 2; wherein both the centrally raised die attachment area 2 and the annular die attachment area 3 are connected to the electrode layer 4.

The substrate 1 can be a ceramic plate, metal plate, or an alloy plate, etc., featuring sufficient hardness, high-temperature resistance, and uniform heat dissipation. Further, the ceramic plate may contain aluminum nitride to enhance the high-temperature resistance. The centrally raised die attachment area 2 and the annular die attachment area 3 are used for mounting the LED chips, connecting to chips, and controlling on and off states of the chips.

The centrally raised die attachment area 2 and the annular die attachment area 3 can both be thick copper layers electroplated on the substrate 1. Both the centrally raised die attachment area 2 and the annular die attachment area 3 are electrically connected to the electrode layer 4, and the circuit connectivity of the electrode layer 4 can control the switching of the chips mounted on the centrally raised die attachment area 2 and the annular die attachment area 3.

A thickness of the centrally raised die attachment area 2 is different from a thickness of the annular die attachment area 3, resulting in the chips mounted on the centrally raised die attachment area 2 on a different plane compared to the chips mounted on the annular die attachment area 3, and staggered in space, which facilitates subsequent mutual coordination of the chips in the two areas and ensures seamless integration of emitted light, thereby improving light uniformity and increasing the illumination range. there may be no spacing between the centrally raised die attachment area 2 and the annular die attachment area 3, ensuring the continuity of emitted light. Electrical connections between the centrally raised die attachment area 2 and the electrode layer 4, as well as between the annular die attachment area 3 and the electrode layer 4, can be established using metallized through-holes.

The embodiment provides a dual die attachment layer LED chip packaging holder and an LED module. The dual die attachment layer LED chip packaging holder of the present disclosure includes a centrally raised die attachment area 2 and an annular die attachment area 3. Both areas are connected to the electrode layer 4, allowing for simultaneous or individual power supply through the electrode layer 4 to enable electrical conduction. Both the centrally raised die attachment area 2 and the annular die attachment area 3 can accommodate LED chips, by adjusting the thickness of the annular die attachment area 3 and the centrally raised die attachment area 2, the optical path of the emitted light can be modified, thereby enhancing the emission range and uniformity of the light.

The dual die attachment layer LED chip packaging holder of the embodiment can be packaged to obtain an LED module. Further, corresponding chips are arranged on the centrally raised die attachment area 2 and the annular die attachment area 3. Depending on the present disclosure scenario, a convex lens or a concave lens can be arranged on the chips for various uses. For example, a convex lens can be mounted to obtain flashlights or streetlights for road illumination, and a convex lens can also be mounted to obtain produce spotlights for exhibition areas, stage lights, or vehicle headlights.

The thickness of the centrally raised die attachment area 2 is different from the thickness of the annular die attachment area 3, allowing for selective activation of chips based on requirement. For example, to achieve a light beam with a smaller divergence angle, only chips in the centrally raised die attachment area 2 can be activated, producing a focused light effect that is nearly parallel. Alternatively, the thickness of the annular die attachment area 3 can be arranged greater than the thickness of the centrally raised die attachment area 2, ensuring that the light emitted from both areas does not interfere or minimally interferes, thus resulting in a light beam that approaches parallelism. Additionally, the intersection point of light paths of the annular die attachment area 3 can locate on a light path of the centrally raised die attachment area 2, enhancing the focusing effect of the emitted light.

To achieve a larger divergence angle, only chips in the annular die attachment area 3 can be activated, resulting in the emitted light being in a laterally defocused state, and increasing the beam divergence angle and producing an effect that approaches a parallel light beam. Alternatively, the thickness of the annular die attachment area 3 can be arranged to be less than the thickness of the centrally raised die attachment area 2, placing chips on both areas in a state of lateral defocus combined with longitudinal defocus. When chips in both areas are simultaneously illuminated, the dual defocus state increases the beam divergence angle, causing the emitted light from both areas to diffuse and overlap, thereby enhancing the diffusion effect. Additionally, it can also prevent the light paths of the annular die attach areas 3 from intersecting, the beam divergence angle can be further increased, enhancing the diffusion effect of the emitted light.

In some embodiments, the thickness of the centrally raised die attachment area 2 is less than the thickness of the annular die attachment area 3, ensuring that the light emitted from chips in both areas does not interfere or minimally interferes with each other, and resulting in a light beam that approaches parallelism, thereby achieving a focused light effect.

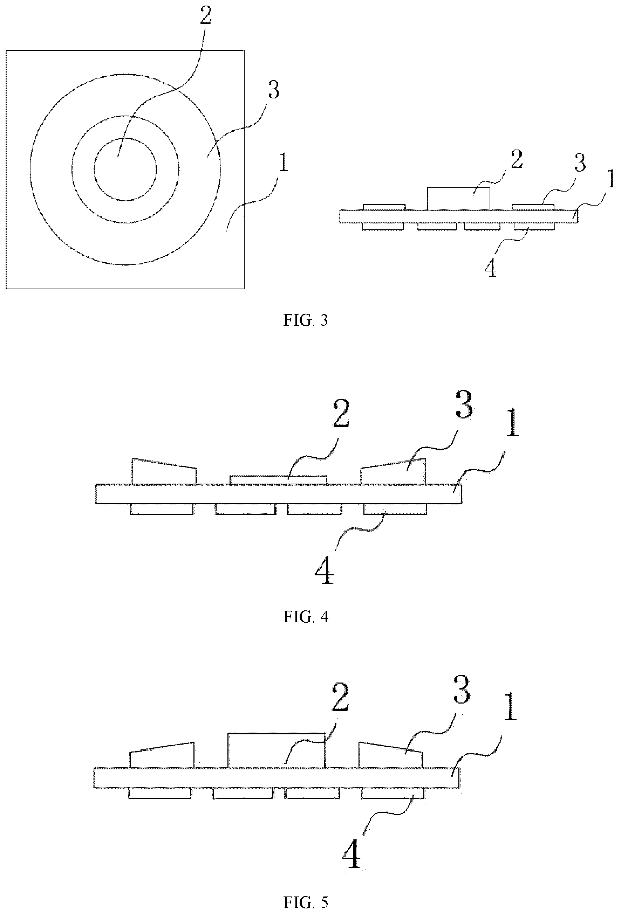

As illustrated in FIG. 4, the thickness of the centrally raised die attachment area 2 is less than the thickness of the annular die attachment area 3; and the thickness of the annular die attachment area 3 decreases gradually in the direction approaching the centrally raised die attachment area 2. The light emitted by chips configured on the annular die attachment area 3 can be gathered, thereby achieving a further concentration of light.

Further, the intersection point of the light paths of the annular die attachment area 3 lies on the light path of the centrally raised die attachment area 2, intersecting the light paths of chips on both areas to reduce the divergence angle between light beams and enhance the focusing effect. The angle between the light paths of the annular die attachment area 3 and the light path of the centrally raised die attachment area 2 is less than 60°, enhancing the brightness of the emitted light and allows for illumination over greater distance.

In some embodiments, the thickness of the centrally raised die attachment area 2 is greater than that of the annular die attachment area 3. The chips on both areas are in a state of lateral defocus combined with longitudinal defocus. When chips in both areas are simultaneously illuminated, the dual defocus state increases the beam divergence angle, causing the light emitted from chips to diffuse and overlap, thereby enhancing the diffusion effect.

As illustrated in FIG. 5, the thickness of the centrally raised die attachment area 2 is greater than that of the annular die attachment area 3. The thickness of the annular die attachment area 3 increases gradually in a direction approaching the centrally raised die attachment area 2, preventing the light paths of the annular die attachment area 3 from intersecting, further increasing the beam divergence angle and enhancing the diffusion effect.

Further, the spacing between the centrally raised die attachment area 2 and the annular die attachment area 3 is less than or equal to the width of the annular die attachment area 3, preventing excessive spacing that could cause uneven light emission or shadows between emitted light beams, thereby ensuring optimal lighting performance.

A first through-hole is arranged in the substrate 1 at a position corresponding to the centrally raised die attachment area 2, and the electrode layer 4 is connected to the centrally raised die attachment area 2 through the first through-hole. A second through-hole is arranged in the substrate 1 at a position corresponding to the annular die attachment area 3, and the electrode layer 4 is connected to the annular die attachment area 3 through the second through-hole.

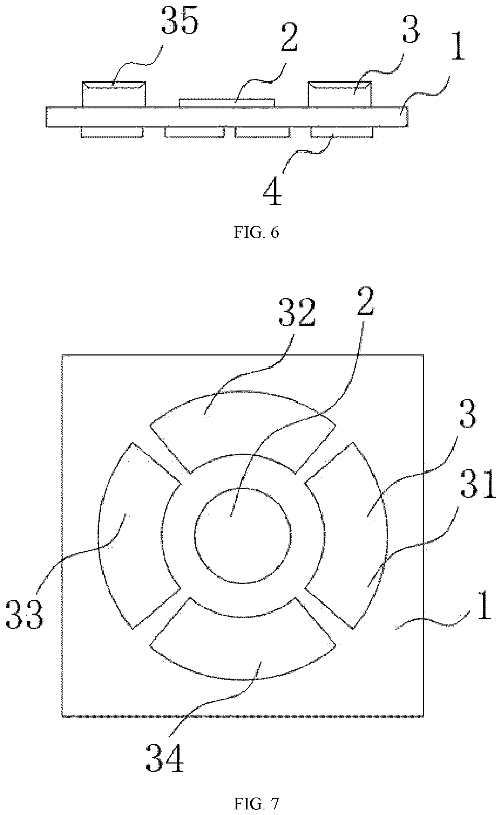

As illustrated in FIG. 6, in some embodiments, the surface of the annular die attachment area 3 can be arranged with connection grooves 35 used for convenient arrangement of chips and improving connection stability. Similarly, the surface of the centrally raised die attachment area 2 can also be provided with connection grooves 35 to enhance the stability of chips.

Further, the electrode layer 4 includes a positive electrode layer and a negative electrode layer, with a gap between the positive electrode layer and the negative electrode layer. The positive electrode layer includes a first positive electrode layer connected to the centrally raised die attachment area 2 and a second positive electrode layer connected to the annular die attachment area 3. Similarly, the negative electrode layer includes a first negative electrode layer connected to the centrally raised die attachment area 2 and a second negative electrode layer connected to the annular die attachment area 3. That is, the gap between the positive layer and the negative layer prevents mutual contact that could cause a short circuit.

Further, both the first positive electrode layer and the first negative electrode layer connect the electrode layer 4 to the centrally raised die attachment area 2, forming a complete circuit to control the electrical conduction status of the centrally raised die attachment area 2. Both the second positive electrode layer and the second negative electrode layer connect the electrode layer 4 to the annular die attachment area 3, forming a complete circuit to control the electrical conduction status of the annular die attachment area 3. Further, a gap is arranged between the first positive electrode layer and the second positive electrode layer, as well as another gap is arranged between the first negative electrode layer and the second negative electrode layer, resulting in independent control of the electrical conduction status of the centrally raised die attachment area 2 and the annular die attachment area 3 through the electrode layer 4, separately.

In some embodiments, the annular die attachment area 3 is composed of a plurality of annular die attachment segments, each of the annular die attachment segment is connected to the electrode layer 4. Intervals can be arranged between the annular die attachment segments. As illustrated in FIG. 7, the annular die attachment area 3 includes a first annular die attachment segment 31, a second annular die attachment segment 32, a third annular die attachment segment 33, and a fourth annular die attachment segment 34. Each of the annular die attachment segments can be individually connected to the electrode layer 4, allowing for separate control of the electrical conduction status of each annular die attachment segment circuit.

Further, the electrode layer 4 includes second positive electrode layers and second negative electrode layers corresponding one-to-one with the plurality of annular die attachment segments, which allows for simultaneous or individual control of the electrical conduction status of each the annular die attachment segment through the electrode layer 4.

Further, an insulating layer can be arranged within the gap between the positive electrode layer and the negative electrode layer. The insulating layer isolates the positive electrode layer and the negative electrode layer to prevent direct contact and short circuits. Additionally, the insulating layer can also be placed within the intervals between the positive electrode layer (such as between the first positive electrode layer and the second positive electrode layer) and between the negative electrode layer (such as between the first negative electrode layer and the second negative electrode layer).

In a second embodiment of the present disclosure, an LED module is provided, which includes a first chip, a second chip, and the dual die attachment layer LED chip packaging holder as described in the first embodiment as well as embodiments thereof; the first chip is arranged on the centrally raised die attachment area 2, and the second chip is arranged on the annular die attachment area 3. The electrode layer 4 enables control over the on or off status of the first chip on the centrally raised die attachment area 2 and the second chip on the annular die attachment area 3.

Further, the LED module can additionally include a protective frame arranged above the first chip and/or the second chip, configured to safeguard the chips from potential damage. Further, the second chip can serve as the chip for a light strip.

Additionally, depending on the actual application requirements, a convex lens or a concave lens may be arranged above the first chip and/or the second chip to alter the emitted light effects.

In summary, the present disclosure includes a dual die attachment layer LED chip packaging holder and an LED module, the dual die attachment layer LED chip packaging holder of the present disclosure includes a centrally raised die attachment area and an annular die attachment area. Both areas are connected to the electrode layer, allowing for simultaneous or individual power supply through the electrode layer to enable electrical conduction. Both the centrally raised die attachment area and the annular die attachment can accommodate LED chips, by adjusting the thickness of the annular die attachment area and the centrally raised die attachment area, the optical path of the emitted light can be modified, thereby enhancing the emission range and uniformity of the light.

Finally, it should be noted that the embodiments are intended to illustrate the technical solutions of the present disclosure and are not meant to limit the scope thereof. Although detailed descriptions have been provided with reference to the aforementioned embodiments, those skilled in the art should understand that modifications to the described technical solutions or equivalent substitutions of some technical features can still be made without departing from the essence and scope of the technical solutions presented in the embodiments of the present disclosure.

## Claims

1. A dual die attachment layer LED chip packaging holder, comprising:
a substrate;
a centrally raised die attachment area, arranged on the substrate;
an annular die attachment area, arranged around an outer side of the centrally raised die attachment area; a thickness of the centrally raised die attachment area is different from a thickness of the annular die attachment area;
an electrode layer, arranged on an end surface of the substrate away from the centrally raised die attachment area; wherein both the centrally raised die attachment area and the annular die attachment area are connected to the electrode layer.

2. The dual die attachment layer LED chip packaging holder according to claim 1, wherein the thickness of the centrally raised die attachment area is less than the thickness of the annular die attachment area; and the thickness of the annular die attachment area decreases gradually in a direction approaching the centrally raised die attachment area.

3. The dual die attachment layer LED chip packaging holder according to claim 2, wherein an intersection point of light paths of the annular die attachment area is located on a light path of the centrally raised die attachment area.

4. The dual die attachment layer LED chip packaging holder according to claim 1, wherein the thickness of the centrally raised die attachment area is greater than the thickness of the annular die attachment area; and the thickness of the annular die attachment area increases gradually in a direction approaching the centrally raised die attachment area.

5. The dual die attachment layer LED chip packaging holder according to claim 1, wherein a spacing between the centrally raised die attachment area and the annular die attachment area is less than or equal to a width of the annular die attachment area.

6. The dual die attachment layer LED chip packaging holder according to claim 1, wherein a first through-hole is arranged in the substrate at a position corresponding to the centrally raised die attachment area, and the electrode layer is connected to the centrally raised die attachment area through the first through-hole; a second through-hole is arranged in the substrate at a position corresponding to the annular die attachment area, and the electrode layer is connected to the annular die attachment area through the second through-hole.

7. The dual die attachment layer LED chip packaging holder according to claim 1, wherein the annular die attachment area comprises a plurality of annular die attachment segments, each of the annular die attachment segments is connected to the electrode layer.

8. The dual die attachment layer LED chip packaging holder according to claim 1, wherein the electrode layer comprises a positive electrode layer and a negative electrode layer, with a gap between the positive electrode layer and the negative electrode layer; the positive electrode layer comprises a first positive electrode layer connected to the centrally raised die attachment area and a second positive electrode layer connected to the annular die attachment area; the negative electrode layer comprises a first negative electrode layer connected to the centrally raised die attachment area and a second negative electrode layer connected to the annular die attachment area.

9. The dual die attachment layer LED chip packaging holder according to claim 8, wherein an insulating layer is arranged within the gap; the insulating layer is configured to electrically isolate the positive electrode layer and the negative electrode layer.

10. An LED module, comprising: a first chip, a second chip, and the dual die attachment layer LED chip packaging holder according to claim 1; wherein the first chip is arranged on the centrally raised die attachment area, and the second chip is arranged on the annular die attachment area.
